Europäisches Patentamt

European Patent Office

Office européen des brevets

(11) Publication number: **0 155 787**
**B1**

(12) **EUROPEAN PATENT SPECIFICATION**

(45) Date of publication of patent specification: **09.01.91**

(51) Int. Cl.⁵: **G 11 C 7/00, G 11 C 8/00, G 11 C 11/24, G 11 C 11/40**

(21) Application number: **85301380.3**

(22) Date of filing: **28.02.85**

(54) Semiconductor memory device.

(30) Priority: **29.02.84 JP 35920/84**

(43) Date of publication of application:
**25.09.85 Bulletin 85/39**

(45) Publication of the grant of the patent:
**09.01.91 Bulletin 91/02**

(84) Designated Contracting States:
**DE FR GB**

(56) References cited:
**GB-A-2 070 372
GB-A-2 092 851
US-A-4 090 096
US-A-4 272 834**

**IBM TECHNICAL DISCLOSURE BULLETIN, vol.
18, no. 8, January 1976, pages 2450-2451, New
York, US; L.M. ARZUBI: "Write/sense for
monolithic memories"**

**PATENT ABSTRACTS OF JAPAN, vol. 3, no. 54,
10th May 1979, page 21 E109; & JP-A-54 32 235
(FUJITSU K.K.) 09-03-1979**

(73) Proprietor: **FUJITSU LIMITED
1015, Kamikodanaka Nakahara-ku
Kawasaki-shi Kanagawa 211 (JP)**

(72) Inventor: **Kawashima, Syoichiro
54, Minamikibogaoka Asahi-ku
Yokohama-shi Kanagawa 241 (JP)**

(74) Representative: **Fane, Christopher Robin King
et al
HASELTINE LAKE & CO. Hazlitt House 28
Southampton Buildings Chancery Lane
London, WC2A 1AT (GB)**

## Description

The present invention relates to a semiconductor memory device.

In general, in a semiconductor memory device, or chip, the time for readout of data from memory cells of the device is shortened by resetting, when the device is in a non-selected state, complementary bit line pairs connected to the memory cells, so that the bit lines in each pair are set to equal potentials. In addition to the bit line pairs, a semiconductor memory device typically has other complementary signal line pairs such as data bus or output line pairs of a sense amplifier. Such complementary signal line pairs may also be reset when the device is not selected. In these cases, it is desired that the resetting of the potential of the bit line pairs or the other complementary signal line pairs be performed reliably no matter how short the duration of the non-selected state, which state is normally maintained by application of a chip non-selection control signal pulse.

In conventional devices the duration of the applied control signal pulse used to delimit the non-selection state is sometimes less than the minimum period needed to enable the bit line pair potentials, or the potentials of other complementary signal line pairs, to be sufficiently reset. In consequence, the unduly long time may be necessary for reading out data from the memory cells.

It is therefore desirable to provide a semiconductor memory device in which, when the applied non-selection control signal pulse is shorter in duration than the said minimum period, the resetting (equalisation) of the bit line pairs is continued for a period at least equal to the said minimum period.

According to the present invention, there is provided a semiconductor memory device, of the kind which can be switched from a selection state to a non-selection state and maintained in the latter state by the application thereto of a control signal pulse, including a pair of signal lines for transferring respective complementary signals, and resetting means actuable, in response to application of the said control signal pulse, to bring about equalisation of the respective potentials of the said signal lines; characterised in that the said resetting means comprise a reset signal generator which operates to provide a reset pulse ensuring that the process of equalisation is continued for a period longer than a predetermined minimum period even if the control signal pulse is shorter than that period.

Reference will now be made, by way of example, to the accompanying drawings, wherein:

Figure 1 is a circuit diagram of a conventional static memory cell;

Figure 2 is a block diagram showing memory chips interconnected together;

Figures 3A and 3B show respective control signals applied to different memory chips of Figure 2;

Figures 4A, 4B and 4C show signal waveforms in a memory chip of Figure 2;

Figure 5 is a circuit diagram of a conventional reset signal generating circuit used in the memory chips of Figure 2;

Figure 6 is a circuit diagram of a conventional address buffer used in the memory chips of Figure 2;

Figure 7 is a graph illustrating operation of the reset signal generating circuit of Figure 5;

Figure 8 is a graph illustrating the variation of access time of one of the memory chips of Figure 2, in dependence upon an applied control signal, when that chip employs the conventional reset signal generating circuit of Figure 5;

Figure 9 is a timing diagram illustrating operation of the reset signal generating circuit of Figure 5;

Figure 10 is a block diagram of resetting means, for use in a semiconductor memory device such as one of the memory chips of Figure 2, according to an embodiment of the present invention;

Figure 11 is a functional block diagram of a reset signal generating circuit in the resetting means of Figure 10;

Figure 12 is a circuit diagram of the reset signal generating circuit of Figure 10; and

Figures 13A to 13H show waveforms making up a timing diagram illustrating operation of the circuit of Figure 12.

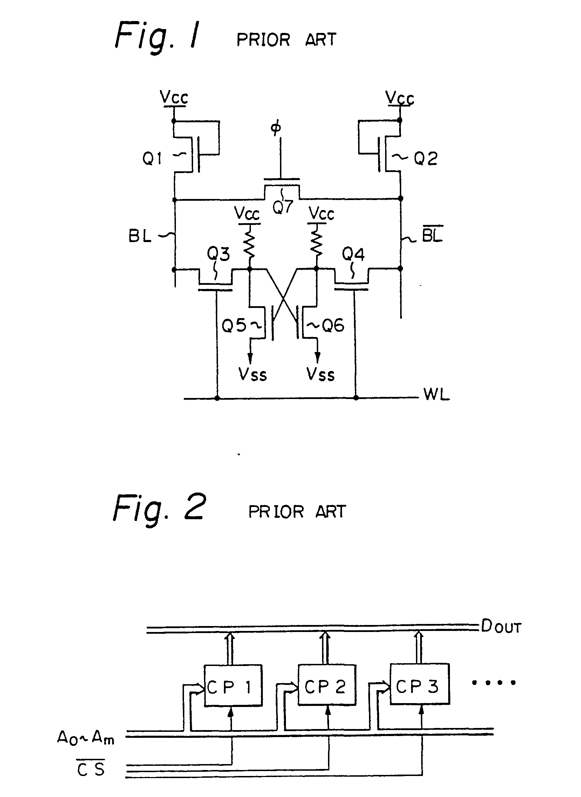

Figure 1 is a circuit diagram showing a static memory cell in which the bit line potentials are reset by a reset signal $\phi$. In the figure 1, Q1 and Q2 are bit line load transistors, Q3 and Q4 transfer gate transistors which are turned on and off by the potential of the word line WL, Q5 and Q6 transistors constituting a flip-flop of the memory cell, and Q7 a reset transistor for bringing about equalisation of the respective potentials of the bit lines BL and $\overline{BL}$ in response to the reset signal.

The reset signal $\phi$ is usually derived from a chip selection control signal $\overline{CS}$ or a change in an address signal.

Figure 2 shows memory chips adapted to receive respective chip selection control signals $\overline{CS}$ and an address signal. Application of a high-logic level potential to the chip selection control signal $\overline{CS}$ input of a memory chip CP1, CP2 or CP3 deselects that chip, reducing its power consumption and setting its outputs to a high impedance state. The chip selection control signal $\overline{CS}$ is also used for generating the reset signal $\phi$ as later described in more detail.

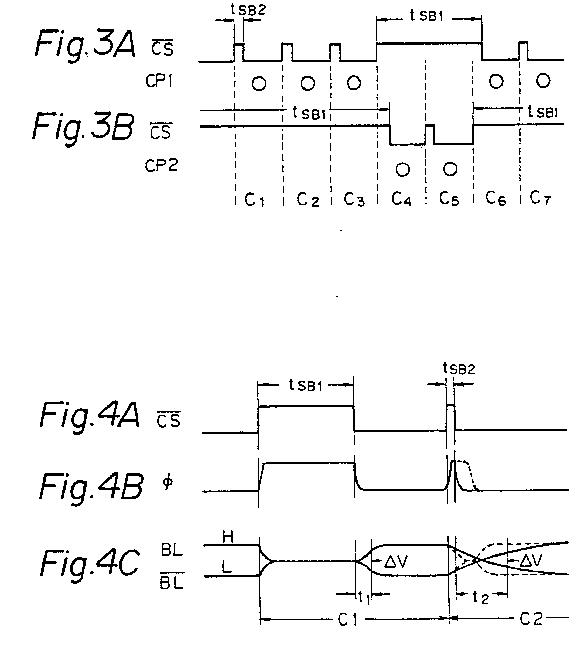

Figures 3A and 3B show high-level pulses of different pulse widths applied to the chip selection control signal input CS. In Figures 3A and 3B, the memory chip CP1 is selected during reading cycles C1, C2, C3, C6, C7, . . ., as indicated by small circles, whereas the memory chip CP2 is selected during reading cycles C4 and C5. During a period in which a chip is deselected, its chip selection control signal $\overline{CS}$ is maintained at a high potential, and accordingly has a relatively large pulse width $t_{SB1}$. However, when a selected chip is to be used in a reading cycle, at the beginning of the cycle a short high-level pulse of width $t_{SB2}$, constituting a chip non-selection control pulse $\overline{CS}$, is applied to the $\overline{CS}$ signal line of that selected memory chip to cause the bit line pairs to be reset.

Figures 4A, 4B, and 4C are waveform diagrams for explaining the operation of the circuit of Figure 1. In the figures, C1 shows a first readout cycle and C2 a second readout cycle. In the first readout cycle C1, a chip non-selection pulse ($\overline{CS}$ = High) of relatively long duration is applied, whereas in the second readout cycle C2, a chip non-selection control pulse of relatively short duration is applied.

Assuming that the reset signal $\phi$ is generated from the chip non-selection control signal $\overline{CS}$, in the first readout cycle C1 in which the long chip non-selection control pulse $\overline{CS}$ is given, the standby time between successive accessing operations involving the memory cells in the non-selected chip is $t_{SB1}$, which is longer than a predetermined minimum period required to enable the bit lines BL and $\overline{BL}$ to be reliably reset to an equal potential by the activated reset signal $\phi$, and thus the potential difference $\Delta V$ between the bit lines BL and $\overline{BL}$ required for the readout of data is obtained a short time $t_1$ after the rise of the associated word line WL. However, in the second readout cycle C2 in which the short chip non-selection control pulse $\overline{CS}$ is applied to the chip, the standby time $t_{SB2}$ of the memory cells is shorter than the predetermined minimum period so that when the word line WL rises the respective potential of the bit lines BL and $\overline{BL}$ are not yet fully equalised. As a result, an undesirably long time $t_2$ is required before the potential difference $\Delta V$ necessary for readout of data is obtained between the bit lines BL and $\overline{BL}$.

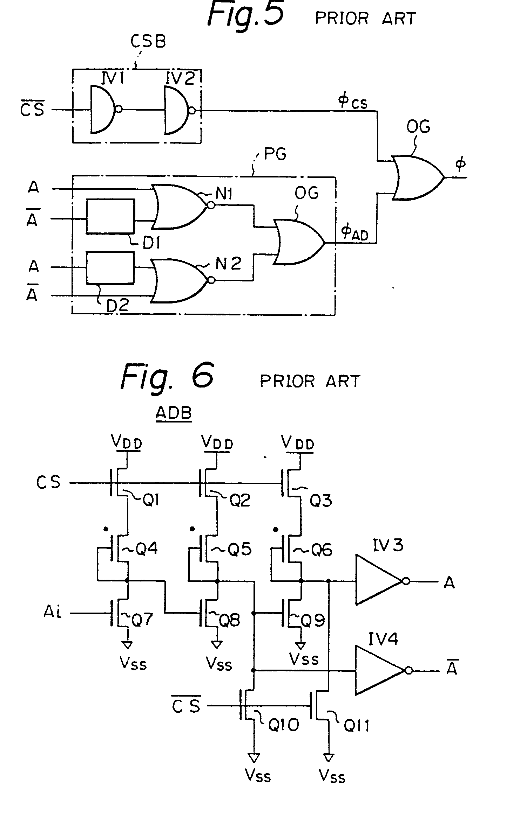

The reset signal $\phi$ is obtained, in practice, either from the chip selection control signal $\overline{CS}$ or from an address change detection, as in the conventional reset signal generating circuit of Figure 5. In Figure 5, the reset signal $\phi$ is obtained by performing a logical OR operation on an output $\phi_{CS}$ of a buffer circuit CSB and an output $\phi_{AD}$ of a pulse generating circuit PG. The buffer circuit CSB includes two inverters IV1 and IV2 which serve to shape the waveform of the chip selection control signal CS to generate a first reset pulse $\phi_{CS}$. The pulse generating circuit PG includes two delay circuits D1 and D2, two NOR gates N1 and N2, and an OR gate OG. The pulse generating circuit PG is well known and is described in, for example, European Patent Unexamined Publication No. 0098164, published on January 11, 1984. Briefly, this reference discloses that the pulse generating circuit PG generates an auxiliary reset pulse $\phi_{AD}$ in response to an address change in the address signal line pairs A and $\overline{A}$.

The respective signal lines of each of the address signal line pairs A and $\overline{A}$ are both reset to a high potential when the chip selection control signal $\overline{CS}$ is maintained at a high potential level (i.e. when the memory chip is in a non-selected state) for a sufficiently long time, in order to speed up the next address change when the memory chip is selected. This resetting of the address signal pairs A and $\overline{A}$ is performed by a conventional address buffer circuit, as shown in Figure 6.

In Figure 6, the address buffer circuit includes enhancement MOS transistors Q1 to Q3 and Q7 to Q11, depletion MOS transistors Q4 to Q6, and two inverters IV3 and IV4. The MOS transistors Q1 to Q3 are connected to receive at their gates a chip selection control signal CS which is inverted with respect to the chip selection control signal $\overline{CS}$. The MOS transistors Q10 and Q11 are connected to receive at their gates the chip selection control signal $\overline{CS}$. The transistor Q7 is connected to receive at its gate an input address signal bit $A_i$ (i.e. $A_0$, $A_1$, ..., $A_m$). While the inverted chip selection control signal CS is at a high potential, the transistors Q1 through Q3 are in an ON state and the transistors Q10 and Q11 are in an OFF state. Therefore, any address change in that input address signal bit $A_i$ causes the address signals A and $\overline{A}$ provided at the outputs of the inverters IV3 and IV4 to undergo mutually-complementary transitions. While the inverted chip selection control signal CS is at a low potential, however, since the transistors Q10 and Q11 are in an ON state, the potentials of the address signals A and $\overline{A}$ are both held at a high potential regardless of any address change in the associated input address signal bit $A_i$.

Accordingly, while the applied chip selection control signal $\overline{CS}$ remains high, the address signals of the signal pair A and $\overline{A}$ are both kept a high potential, and the pulse generating circuit PG in the circuit shown in Figure 5 is inhibited from generating the auxiliary reset pulse $\phi_{AD}$, even if an address change occurs in the input address signal $A_i$. In this case, therefore, the reset signal $\phi$ is provided solely by the reset pulse $\phi_{CS}$.

However, if the time for which the chip selection control signal $\overline{CS}$ is high is very short, or if the signal $\overline{CS}$ remains at a low potential over successive memory access cycles, the potentials of the address signals A and $\overline{A}$ will change in response to any address change in the input address bits $A_i$, so that the auxiliary reset pulse $\phi_{AD}$ is generated.

Accordingly, when the signal CS remains at a low potential so that no reset pulse $\phi_{CS}$ is produced by the buffer circuit CSB, the required bit line reset signal $\phi$ will still be produced at the time of a change in the applied address bits $A_i$ by operation of the address buffer circuit ADB and pulse generating circuit PG. Thus, the circuits ADB and PG together constitute auxiliary resetting means of the chip. On the other hand, when a CS pulse is applied that is very short, the auxiliary reset pulse $\phi_{AD}$ has a pulse width longer than that of the reset pulse $\phi_{CS}$, so that the resulting pulse in the reset signal $\phi$ is prolonged for the duration of the reset pulse $\phi_{AD}$.

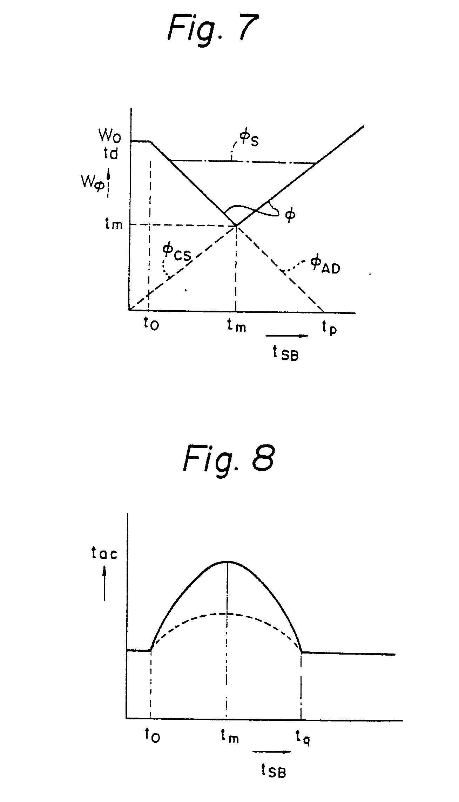

Figure 7 is a graph showing the relationship between the pulse width $t_{SB}$ of the chip non-selection control pulse, i.e. the time for which the applied chip selection signal $\overline{CS}$ is high, and the pulse width $W_0$ of the reset signal $\phi$. As shown in Figure 7, when the pulse width $t_{SB}$ is smaller than a predetermined value $t_0$, the pulse width of the auxiliary reset pulse $\phi_{AD}$ is constant, i.e. $W_0$. When the pulse width $t_{SB}$ is greater than $t_0$, the pulse width of the auxiliary reset signals $\phi_{AD}$ decreases linearly as the pulse width $t_{SB}$ of the chip non-selection control pulse $\overline{CS}$ increases, until the pulse width $t_{SB}$ reaches a value $t_p$. When the pulse width $t_{SB}$ is greater than $t_P$, the auxiliary reset pulse $\phi_{AD}$ is not generated even when the input the address signal $A_i$ is changed. The pulse width of the reset pulse $\phi_{CS}$, as expected, increases with the pulse width $t_{SB}$. The reset signal $\phi$ is the logical OR of the reset signal $\phi_{CS}$ and the auxiliary reset signal $\phi_{AD}$, as mentioned above. Therefore, as illustrated by a solid curve in Figure 7, when the pulse width $t_{SB}$ is less than a value $t_m$ the pulse width of the reset signal $\phi$ is determined by the auxiliary reset pulse $\phi_{AD}$ and decreases as the pulse width $t_{SB}$ increases from the value $t_0$ to the value $t_m$, at which the respective pulse widths of the two reset pulses $\phi_{CS}$ and $\phi_{AD}$ are both equal to $t_m$. When the pulse width $t_{SB}$ is greater than the value $t_m$, the pulse width of the reset signal $\phi$ is determined by the reset pulse $\phi_{CS}$.

Accordingly, the pulse width of the reset signal is at a minimum when the chip non selection control pulse has a pulse width $t_m$. As described with reference to Figure 2, if the pulse width of the reset signal $\phi$ is too small, the bit line pair is not shorted fully, thereby prolonging reading access time.

Figure 8 shows the relationship between the pulse width $t_{SB}$ of the chip non-selection control pulse and accessing time $t_{ac}$. As can be seen from Figure 8, the accessing time $t_{ac}$ is at a maximum when the pulse width of the chip non-selection control pulse is equal to the value $t_m$. When the pulse width $t_{SB}$ is shorter than the value $t_0$, the reset signal $\phi$ is derived from the auxiliary reset pulse $\phi_{AD}$ which, in this case, is not affected by variations in the width of the chip non-selection control pulse so that a constant short access time is obtained. Also, when the pulse width $t_{SB}$ is longer than a predetermined value $t_q$, the bit line pair BL and $\overline{BL}$ is properly reset by the reset signal derived from the reset pulse $\phi_{CS}$ before the next access is made, so that a constant short access time is obtained.

It is accordingly desirable to reduce the access time when the pulse width $t_{SB}$ of the chip non-selection control pulse $\overline{CS}$ is within the critical range of values from $t_0$ to $t_q$, for example so that access times as illustrated by the dashed curve in Figure 8 are obtained.

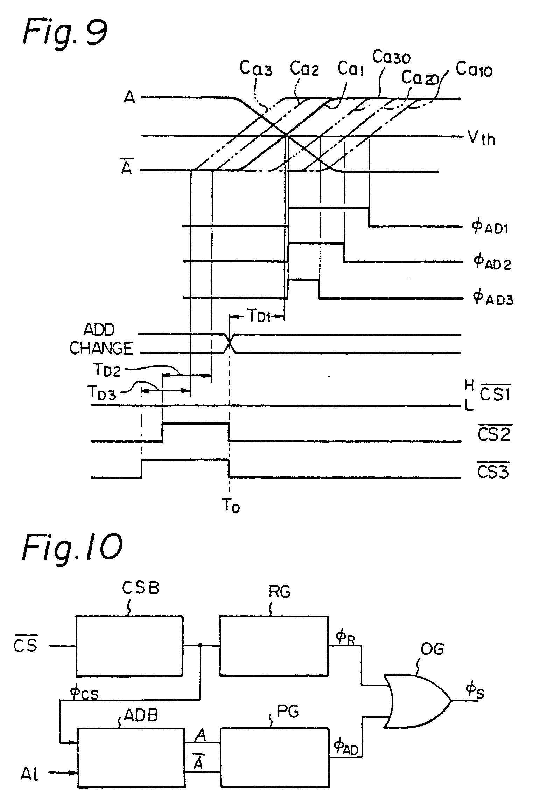

The decrease in pulse width of the auxiliary reset pulse $\phi_{AD}$ as the pulse width of the chip non-selection control pulse $\overline{CS}$ increases may be better understood from Figure 9, which shows the effect of variations in the pulse width $t_{SB}$ of the chip non-selection control pulse on the pulse width of the auxiliary reset pulse produced at each change in the applied address data. In Figure 9, a change in the applied address bits $A_i$ at time $T_0$ causes the address signals A and $\overline{A}$ to undergo complementary transitions, such that after a time $T_{D1}$ they reach a threshold voltage value $V_{th}$, provided that the signal $\overline{CS}$ remains low as shown by $\overline{CS1}$. In this case, the waveform of the address signal $\overline{A}$ is denoted by $C_{a1}$ in the figure.

However, if the chip control signal $\overline{CS}$ is at a high level H, before the time $T_0$, as shown by CS2 or CS3, the address signal A rises earlier than is indicated by the waveform $C_{a1}$. The longer the pulse width of the chip non-selection control pulse $\overline{CS}$, i.e. the earlier the rise in the signal $\overline{CS}$, the earlier the address signal $\overline{A}$ will rise. In Figure 9, $T_{D2}$ and $T_{D3}$ represent delay times between the respective rises in the chip control signals $\overline{CS2}$ and $\overline{CS3}$ and the resulting rises in the address signal $\overline{A}$ shown respectively by waveforms $C_{a2}$ and $C_{a3}$. In the delay circuit D1 in the circuit shown in Figure 5, the applied waveform $C_{a1}$, $C_{a2}$, or $C_{a3}$ is delayed to produce a corresponding delayed output waveform $C_{a10}$, $C_{a20}$, or $C_{a30}$. While the output waveform $C_{a10}$, $C_{a20}$, or $C_{a30}$ is below the threshold value $V_{th}$, the auxiliary reset pulse $\phi_{AD1}$, $\phi_{AD2}$, or $\phi_{AD3}$ is produced. As will be observed, the pulse width of the auxiliary reset pulse $\phi_{AD}$ decreases as the pulse width of the chip non-selection control pulse CS increases.

Figure 10 is a block diagram showing resetting means, for use in a semiconductor memory device, according to an embodiment of the present invention. In Figure 10, the buffer circuit CSB, and the auxiliary resetting means comprising the address buffer circuit ADB and the pulse generating circuit PG, are the same as the conventional circuits shown in Figures 5 and 6. In the illustrated embodiment of the present invention, however, a reset signal generating circuit RG is provided between the buffer circuit CSB and the OR gate OG.

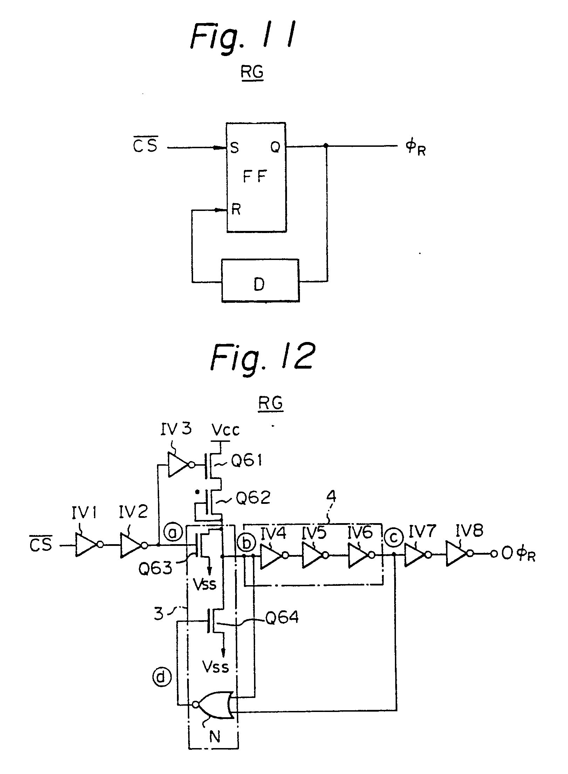

Figure 11 is a functional block diagram of the reset signal generating circuit RG of Figure 10, which circuit includes an R—S flip-flop and a delay circuit as principal functional elements. The R—S flip-flop FF receives a chip selection control signal $\overline{CS}$ at its set terminal S and is connected to an output of the delay circuit D at its reset terminal R. The delay circuit D delays the signal provided at an output Q of the flip-flop FF by a period equal to the above-mentioned predetermined minimum period needed for equalisation of the respective potentials of each of the bit line pairs. The potential at the output Q of the flip-flop FF is set to the H level in response to the rise of the chip selection control signal $\overline{CS}$. The output Q remains at the H level for a period slightly longer than the above-mentioned predetermined minimum period, whereafter the potential at the output Q is reset to the L level by the delay circuit D. Thus, a bit line reset pulse $\phi_R$ longer slightly in duration than the predetermined minimum period is obtained at the output Q of the flip-flop FF.

Figure 12 is a circuit diagram of the reset signal generating circuit RG of Figure 10.

In Figure 12, transistors Q61, Q62 and Q63 are connected in series through their drains and sources between power sources $V_{CC}$ and $V_{SS}$. The respective drains of the transistors Q63 and Q64 are connected together. The source of the transistor Q64 is connected to the power source $V_{SS}$. In this way, the transistors Q63 and Q64 form part of a NOR gate. The gate of the transistor Q61 is supplied with an inverted version of the chip selection control signal $\overline{CS}$ by way of inverters IV1, IV2, and IV3. The gate of the transistor Q63 is supplied with the chip selection control signal $\overline{CS}$ by way of the inverters IV1 and IV2. The commonly connected drains of the transistors Q63 and Q64 are connected to a first input of a NOR gate N (of the same construction as the above-mentioned NOR gate employing the transistors Q63 and Q64) and also to an output terminal O by way of the inverters IV4 to IV8. The output of the inverter IV6 is connected to the second input of the NOR gate N. The output of the NOR gate N is connected to the gate of the transistor Q64. The transistor Q62 is a depletion transistor and its gate and source are short circuited. The transistors Q61, Q63, and Q64 are N channel enhancement transistors.

The transistors Q61 and Q63 form a push-pull circuit, in which in the static condition one transistor is always OFF while the other is ON, and together function as a waveshaping circuit. The transistor Q62 serves as a current limiting transistor in the transitional period when Q61 and Q63 are both ON. The transistors Q63 and Q64 and the NOR gate N form a flip-flop 3 which is set when the chip selection control signal $\overline{CS}$, supplied to the gate of Q63, is high and reset when the output of the NOR gate N, supplied to the gate Q64, is low. The inverters IV4, IV5 and IV6 form an inverting delay circuit 4 which delays transmission of an output signal provided at an inverting output of the flip-flop 3 to the second input of the NOR gate N by a period equal to the abovementioned predetermined minimum period necessary for equalising the bit line potentials.

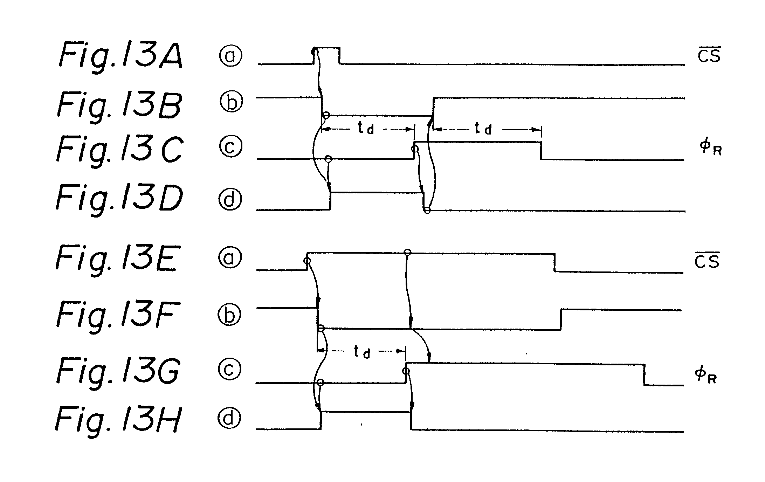

The operation of the circuit of Figure 12 will be explained with reference to Figures 13A to 13H. Figures 13A to 13D show the case where the pulse width of the chip non-selection control pulse $\overline{CS}$ is shorter than the predetermined minimum period, and Figures 13E to 13H show the case where the pulse width of the chip selection control signal $\overline{CS}$ is longer than that period.

In Figures 13A to 13D, when the chip selection control signal $\overline{CS}$ rises, the potential at a point ⓐ in the circuit of Figure 12 rises through the action of the inverters IV1 and IV2. Upon this rising edge, the transistor Q63 is turned ON and the potential of point ⓑ of Figure 12 falls. The output of the NOR gate N at the point ⓓ becomes high level because both of its inputs (at the points ⓑ and ⓒ of Figure 12) are at the low level. Thus, the transistor Q64 is turned ON and the output (point ⓓ) of the flip-flop 3 is latched at the low level. For this reason, even if the chip non-selection pulse ends, i.e. $\overline{CS}$ falls, the potential of point ⓑ is held at the low level. The change from the high level to the low level at point ⓑ causes, by way of the inverters IV4, IV5 and IV6, a change from the low level to high level at point ⓒ a predetermined delay time $t_d$ later. When point ⓒ becomes high level, the output of the NOR gate N at point ⓓ falls to the low level. Thus, the transistor Q64 becomes OFF, the flip-flop 3 is reset, and the potential of point ⓑ rises to the high level. Therefore, a time slightly longer than the predetermined time $t_d$ after rising, the potential of point ⓒ falls to the low level. The resultant point at point ⓒ accordingly has a width greater than or equal to the predetermined time $t_d$ and is output as the bit line reset pulse $\phi_R$ through the inverters IV7 and IV8 at the output terminal O.

In Figures 13E through 13H, the flip-flop 3 is set by the rise of the potential of point a in the same way as in Figures 13A to 13D. Unlike in the case of Figure 13A, however, as shown in Figure 13E, the applied signal $\overline{CS}$ does not fall quickly again. The predetermined time $t_d$ after the fall of the potential at point ⓑ, the potential of point ⓒ rises and the potential of the output point ⓓ of the NOR gate N falls. The applied chip selection control signal $\overline{CS}$ in this case, however, is maintained at the high level after the potential at point ⓓ has fallen. Therefore, since the level of point ⓐ is high, the transistor Q63 remains on and the potential of point ⓑ is held at the low level. In this case, the potential of point ⓒ, and therefore the potential at the output terminal O, follows that of the chip selection control signal $\overline{CS}$ a delay time substantially equal to the time $t_d$ later. Thus, the pulse width of the bit line reset signal $\phi_R$ is substantially the same as the pulse width of the chip non-selection control pulse $\overline{CS}$.

Accordingly, even when the above-mentioned auxiliary pulse reset $\phi_{AD}$ has an undesirably small pulse width due to an applied chip non-selection control pulse $\overline{CS}$ of pulse width within the critical range discussed with reference to Figures 7 to 9, a bit line reset pulse $\phi_R$ having a pulse width greater than that of the auxiliary reset pulse $\phi_{AD}$ is generated and supplied through the OR gate OG in Figure 10, to provide a satisfactory reset signal $\phi_S$, as explained with reference to Figures 13A through 13H.

Since the minimum pulse width of the reset signal $\phi_R$ provided by the circuit RG is slightly greater than the predetermined time $t_d$ necessary for quickly resetting the potentials of the bit line pair, as illustrated in Figure 7 by a dash-dot line the access time $t_{ac}$ when the chip non-selection control pulse $\overline{CS}$ has a pulse width in the aforesaid critical range between $t_o$ and $t_q$ in Figure 8 can be shortened. In other words, as shown by dash lines in Figures 4A, 4B and 4C a chip non-selection control pulse $\overline{CS}$ having a pulse width $t_{SB2}$ within the critical range is effectively elongated, and the bit line pair is reset desirably quickly, so that the access time is shortened in comparison with the prior art.

The reset signal generating circuit shown in Figure 12 may be used not only for resetting the bit line pairs in a semiconductor memory device having static memory cells shown in Figure 1, but also as a reset circuit in other semiconductor memory devices. For example, any other complementary signal line pairs such as data bus or output line pairs of a sense amplifier may also be reset by a reset signal generating circuit according to the present invention. Further, it may be applied to semiconductor circuits in general which are designed to receive chip selection signals and to generate in dependence thereupon a reset signal when the chip is not selected.

**Claims**

1. A semiconductor memory device, of the kind which can be switched from a selection state to a non-selection state and maintained in the latter state by the application thereto of a control signal pulse ($\overline{CS}$), including a pair of signal lines (BL, $\overline{BL}$) for transferring respective complementary signals, and resetting means (RG, OG, $Q_7$) actuable, in response to application of the said control signal pulse, to bring about equalisation of the respective potentials of the said signal lines (BL, $\overline{BL}$), characterised in that the said resetting means comprise a reset signal generator (RG) which operates to provide a reset pulse ($\phi_R$) ensuring that the process of equalisation is continued for a period longer than a predetermined minimum period ($t_d$) even if the control signal pulse ($\overline{CS}$) is shorter than that period ($t_d$).

2. A device as claimed in claim 1, further including auxiliary resetting means comprising an address buffer circuit (ADB), operable in response to an address signal change to produce respective complementary signal changes at two outputs (A, $\overline{A}$) thereof, and a pulse generating circuit (PG) having inputs connected respectively to the said outputs (A, $\overline{A}$) of the address buffer circuit and operable in response to such complementary signal changes to bring about equalisation of the respective potentials of the said signal lines (BL, $\overline{BL}$) if the resetting means of claim 1 is not actuated at the time of the said address signal change, the said pulse generating circuit (PG) being such as to provide an auxiliary reset pulse ($\phi_{AD}$) ensuring that the process of equalisation brought about thereby continues for a period longer than the said predetermined minimum period.

3. A device as claimed in claim 2, such that when the resetting means of claim 1 is actuated at the time of the said address signal change, a resulting process of equalisation of the said respective potentials is continued for a period determined by whichever of the two reset pulses ($\phi_R$, $\phi_{AD}$) is the longer.

4. A device as claimed in claim 2 or 3, wherein the said address buffer circuit (ADB) is such that increase in length of the said control signal pulse ($\overline{CS}$) produces a decrease in length of the said auxiliary reset pulse ($\phi_{AD}$).

5. A device as claimed in any preceding claim, wherein the said signal lines (BL, $\overline{BL}$) constitute a bit line pair.

6. A device as claimed in any preceding claim, wherein the said reset signal generator (RG) comprises a flip-flop (FF), connected to be set by application thereto of the said control signal pulse ($\overline{CS}$), having an output (Q) connected to a reset input (R) thereof by way of a delay circuit (D), for delaying transmission of an output signal of the flip-flop to its reset input by a period equal to the said predetermined minimum period, the reset pulse ($\phi_R$) of claim 1 being derived from the said output signal of the flip-flop.

**Patentansprüche**

1. Halbleiterspeichervorrichtung von der Art, die von einem ausgewählten Zustand in einen nichtausgewählten Zustand geschaltet und in dem letztgenannten Zustand durch Anwendung eines Steuersignalimpulses ($\overline{CS}$) auf sie gehalten werden kann, mit einem Paar von Signalleitungen (BL, $\overline{BL}$), zum Transferieren entsprechender komplementärer Signale, und eine Rücksetzeinrichtung (RG, OG, $Q_7$), die ansprechend auf die Anwendung des genannten Steuersignalimpulses betätigbar ist, um einen Ausgleich der entsprechenden Potentiale der genannten Signalleitungen (BL, $\overline{BL}$) herbeizuführen, dadurch gekennzeichnet, daß die genannte Rücksetzeinrichtung einen Rücksetzsignalgenerator (RG) umfaßt, welcher betreibbar ist, um einen Rücksetzimpuls ($\phi_R$) zu liefern, der gewährleistet, daß das Verfahren des Ausgleichs für eine Periode länger als eine vorbestimmte minimale Periode ($t_d$) fortgesetzt wird, auch falls der Steuersignalimpuls ($\overline{CS}$) kürzer als jene Periode ($t_d$) ist.

2. Vorrichtung nach Anspruch 1, ferner mit einer Hilfsrücksetzeinrichtung, die eine Adreßpufferschaltung (ADB) umfaßt, die ansprechend auf eine Adreßsignaländerung betätigbar ist, um entsprechende komplementäre Signaländerungen an ihren beiden Ausgängen (A, $\overline{A}$) zu erzeugen, und einer Impulsgeneratorschaltung (PG), die Eingänge hat, welche jeweils mit den genannten Ausgängen (A, $\overline{A}$) der Adreßpufferschaltung verbunden sind, und ansprechend auf solch komplementäre Signaländerungen betreibbar ist, um einen Ausgleich der entspechenden Potentiale der genannten Signalleitungen (BL, $\overline{BL}$) herbeizuführen, falls die Rücksetzeinrichtung nach Anspruch 1 zu der Zeit der genannten Adreßsignaländerung nicht betätigt wird, wobei die genannte Impulsgeneratorschaltung (PG) derart ist, daß sie einen Hilfsrücksetzimpuls ($\phi_{AD}$) liefert, der gewährleistet, daß der Prozeß des dadurch herbeigeführten Ausgleichs für eine Periode länger als die genannte vorbestimmte Minimalperiode fortgesetzt wird.

3. Vorrichtung nach Anspruch 2, so daß dann, wenn die Rücksetzeinrichtung nach Anspruch 1 zu der Zeit der genannten Adreßsignaländerung betätigt wird, ein resultierender Prozeß des Ausgleichs der genannten entsprechenden Potentiale für eine Periode fortgesetzt wird, die bestimmt ist durch den jeweils längeren der beiden Rücksetzimpulse ($\phi_R$, $\phi_{AD}$).

4. Vorrichtung nach Anspruch 2 oder 3, bei der die genannte Adreßpufferschaltung (ADB) derart ist, daß eine Erhöhung der Länge des genannten Steuersignalimpulses ($\overline{CS}$) eine Verringerung der Länge des genannten Hilfsrücksetzimpulses ($\phi_{AD}$) erzeugt.

5. Vorrichtung nach einem der vorhergehenden Ansprüche, bei der die genannten Signalleitungen (BL, $\overline{BL}$) ein Bitleitungspaar bilden.

6. Vorrichtung nach einem der vorhergehenden Ansprüche, bei der der genannte Rücksetzsignalgenerator (RG) eine Flipflop (FF) umfaßt, das angeschlossen ist, um durch Anwendung des genannten Steuersignalimpulses ($\overline{CS}$) gesetzt zu werden, mit einem Ausgang (Q), der mit einem Rücksetzeingang (R) von ihm über eine Verzögerungsschaltung (D) verbunden ist, zur Verzögerung der Übertragung eines Ausgangssignals des Flipflops zu seinem Rücksetzeingang um eine Periode, die gleich der genannten vorbestimmten Minimalperiode ist, wobei der Rücksetzimpuls ($\phi_R$) von Anspruch 1 von dem genannten Ausgangssignal des Flipflops abgeleitet ist.

**Revendications**

1. Dispositif de mémoire à semiconducteur du type qui peut être commuté d'un état de sélection à un état de non-sélection et maintenu dans le dernier état par l'application à celui-ci d'une impulsion de signal de commande ($\overline{CS}$), incluant une paire de fils de signaux (BL, $\overline{BL}$) pour transférer des signaux complémentaires respectifs, et des moyens de remise à l'état initial (RG, OG, Q7) pouvant être rendus actifs, en réponse à l'application de l'impulsion de signal de commande, pour produire l'égalisation des potentiels respectifs des fils de signaux (BL, $\overline{BL}$), caractérisé en ce que les moyens de remise à l'état initial comprennent un générateur de signaux de remise à l'état initial (RG) qui fonctionne pour fournir une impulsion de remise à l'état initial ($\phi_R$) garantissant que l'opération d'égalisation est poursuivie pendant une période plus longue qu'une période minimale prédéterminée ($t_d$), même si l'impulsion de signal de commande ($\overline{CS}$) est plus courte que la période ($t_d$).

2. Dispositif selon la revendication 1, incluant en outre un moyen de remise à l'état initial auxiliaire comprenant un circuit tampon d'adresse (ADB), pouvant être mis en fonctionnement en réponse à un changement de signal d'adresse pour produire des changements de signaux complémentaires à ses deux sorties (A, $\overline{A}$), et un circuit générateur d'impulsions (PG) ayant des entrées connectées respectivement aux sorties (A, $\overline{A}$) du circuit tampon d'adresse et pouvant être mis en fonctionnement en réponse à ces changements de signaux complémentaires pour produire l'égalisation des potentiels respectifs des fils de signaux (BL, $\overline{BL}$) si les moyens de remise à l'état initial de la revendication 1 ne sont pas rendus actifs au temps du changement de signal d'adresse, le circuit générateur d'impulsion (PG) étant tel qu'il fournit une impulsion de remise à l'état initial ($\phi_{AD}$) garantissant que l'opération d'égalisation produite par celui-ci se poursuit pendant une période plus longue que la période minimale prédéterminée.

3. Dispositif selon la revendication 2, tel que, lorsque les moyens de remise à l'état initial de la revendication 1 sont rendus actifs au temps du changement de signal d'adresse, une opération résultante d'égalisation des potentiels respectifs est poursuivie pendant une période déterminée par celle des deux impulsions de remise à l'état initial ($\phi_R$, $\phi_{AD}$) qui est la plus longue.

4. Dispositif selon l'une quelconque des revendications 2 et 3, dans lequel le circuit tampon d'adresse (ADB) est tel qu'une augmentation de la longueur de l'impulsion de signal de commande ($\overline{CS}$) produit une diminution de longueur de l'impulsion de remise à l'état initial auxiliaire ($\phi_{AD}$).

5. Dispositif selon l'une quelconque des revendications 1 à 4, dans lequel les fils de signaux (BL, $\overline{BL}$) constituent une paire de fils de bit.

6. Dispositif selon l'une quelconque des revendications 1 à 5, dans lequel le générateur de signaux de remise à l'état initial (RG) comprend une bascule (FF), connectée pour être positionnée par l'application à celle-ci de l'impulsion de signal de commande ($\overline{CS}$), ayant une sortie (Q) connectée à une entrée de remise à l'état initial (R) de celle-ci au moyen d'un circuit à retard (D), pour retarder la transmission d'un signal de sortie de la bascule à son entrée de remise à l'état initial d'une période égale à la période minimale prédéterminée, l'impulsion de remise à l'état initial ($\phi_R$) de la revendication 1 étant dérivée du signal de sortie de la bascule.

# Fig. 1    PRIOR ART

# Fig. 2    PRIOR ART

EP 0 155 787 B1

Fig.3A $\overline{CS}$

Fig.3B $\overline{CS}$

Fig.4A $\overline{CS}$

Fig.4B $\phi$

Fig.4C $\frac{BL}{\overline{BL}}$

2

## Fig.5  PRIOR ART

CSB

IV1  IV2

$\overline{CS}$

$\phi_{CS}$

OG

$\phi$

PG

A

$\overline{A}$

D1

N1

OG

A

$\overline{A}$

N2

$\phi_{AD}$

D2

## Fig. 6  PRIOR ART

ADB

$V_{DD}$   $V_{DD}$   $V_{DD}$

CS

Q1   Q2   Q3

Q4   Q5   Q6

IV3

A

Ai

Q7   Q8   Q9

$V_{SS}$   $V_{SS}$   $V_{SS}$

IV4

$\overline{A}$

$\overline{CS}$

Q10   Q11

$V_{SS}$   $V_{SS}$

3

## Fig. 7

## Fig. 8

## Fig. 9

## Fig. 10

# Fig. 11

<u>RG</u>

# Fig. 12

<u>RG</u>

6

Fig.13A ⓐ — $\overline{CS}$

Fig.13B ⓑ

Fig.13C ⓒ — $\phi_R$

Fig.13D ⓓ

$t_d$

Fig.13E ⓐ — $\overline{CS}$

Fig.13F ⓑ

Fig.13G ⓒ — $\phi_R$

Fig.13H ⓓ

$t_d$

EP 0 155 787 B1